# EUROPEAN PATENT APPLICATION

(11) **EP 2 081 032 A1**
(43) Date of publication of application: **22.07.2009**
(21) Application number: 08100712.2
(22) Date of filing: 21.01.2008
(51) Int. Cl.: G01R 29/08

(54) **Apparatus and method for detecting electromagnetic radiation emitted by a device**

(71) Applicant: Queen Mary University of London, London Greater London E1 4NS (GB)
(72) Inventor: Chen, Xiaodong, London, E1 4NS (GB); Gao, Yue, London, E1 4NS (GB); Guo, Lu, London, E1 4NS (GB); Dupuy, John, London, E1 4NS (GB)
(74) Representative: Chandrani, Vandita

(57) **Abstract**

Apparatus and a method for detecting electromagnetic radiation emitted by a device, the device including multiple components that emit electromagnetic radiation. The apparatus comprises a container lined with electromagnetic anechoic absorber, a support located within the container for receiving the device, a planar antenna located within the container for detecting electromagnetic radiation emitted by the device, the antenna being movable relative to the support to vary the distance between the antenna and the support, and measurement apparatus for recording the electromagnetic radiation emitted by the device at different positions of the antenna relative to the support.

## Description

The present invention relates to apparatus and a method for detecting electromagnetic radiation emitted by a device, the device including multiple components that emit electromagnetic radiation.

Current wireless devices, such as cellular telephones, typically contain several components that may emit electromagnetic radiation. In a typical cellular phone, in addition to the circuitry required for the cellular phone to operate as a traditional telephone, the cellular telephone may also include, for example, a radio, an MP3 player, Bluetooth connections, Wireless Application Protocol, a camera and the like.

Each of these independent components emits its own electromagnetic radiation. The amount of electromagnetic radiation emitted by each independent component is currently tested to ensure that it conforms to a specific standard. However, no consideration is given to how the electromagnetic radiation emitted by the different components interacts and affects the performance of the cellular phone itself. The combined electromagnetic radiation emitted from the various components and the way the different electric fields interact can interfere with the sensitivity of an antenna located on the phone. The internal antenna of a cellular phone is located in close proximity to all other components of the cellular phone and as the noise levels of each of the independent components increases, the internal interference for the antenna also increases.

As a result of the additional noise and interference resulting from the additional components included in a phone, the noise discrimination levels of antennae in cellular phones can be reduced from -110dB to approximately -90dB. At this level, it may be necessary to move closer to a base station in order to get entirely clear reception.

Various attempts have been made to design cellular phones where the antenna is shielded from internal electromagnetic radiation emitted by other components of the phone. For example, US 2007/0109196 discloses a cellular phone incorporating a shielding metal wall around the antenna to reduce the interference resulting from nearby electronic components. However, no method is disclosed that enables testing of the equipment to ascertain if the shielding has been effective.

Methods exist for detecting the total electromagnetic radiation emitted from a device. Such methods and devices are used to ensure that each cellular phone or wireless device complies with the different standards that exist for ensuring that the overall electromagnetic radiation emitted from such a device does not exceed a level that is considered to be safe.

For example, a manual by ETS-Lindgren entitled "Model 5220 Bluetooth Interface Testing System (BIT^{™}) Manual" discloses test equipment including a shielded box, lined with RF anechoic absorber for testing electromagnetic radiation of small wireless devices. An array of antennae is provided within the box for detecting the electromagnetic radiation emitted from a device placed in the box. It is expected that the total electromagnetic radiation emitted from the device as a whole would be significantly greater than the electromagnetic radiation emitted by individual components of a phone.

Yixin Feng and Zhinong Ying in a paper entitled "Evaluation of the Cobra Antenna for EMC Measurements" have disclosed equipment for detecting the electromagnetic radiation of individual components in a wireless device using a so-called "Cobra" antenna. In the test equipment a wireless device is placed underneath and in close proximity to an antenna. The antenna is connected to a spectrum analyser and various tests are carried out with different components of the cellular phone switched on. For example, in one test only the camera is switched on and in another only the display is switched on. The antenna features a broadband characteristic from 800 MHz to 8 GHz, and the testing equipment can detect a minimum noise level around -115 dBm. However, the equipment described above is not sensitive enough to enable reliable and verifiable electromagnetic compatibility (EMC) testing that may be used commercially.

According to a first aspect of the present invention, there is provided apparatus for detecting electromagnetic radiation emitted by a device, the device including multiple components that emit electromagnetic radiation, the apparatus comprising a container lined with electromagnetic anechoic absorber; a support located within the container for receiving the device; a planar antenna located within the container for detecting electromagnetic radiation emitted by the device, the antenna being movable relative to the support to vary the distance between the antenna and the support; and measurement apparatus for recording the electromagnetic radiation emitted by the device at different positions of the antenna relative to the support. Preferably, the support is formed of a portion of the said electromagnetic anechoic absorber positioned at the base of the container.

By providing a container lined with electromagnetic anechoic absorber, measurements can be taken, within the container, of electromagnetic radiation emitted by a device, without having to take account of interference or noise from external devices and as a result, performance of the antenna is improved. The distance between the antenna and a device placed on the support is variable so that it is possible to find the optimum position of the antenna relative to the device for detecting electromagnetic radiation of components of the device. By using a planar antenna it is possible to position the antenna very close to the device without detuning the antenna.

In an embodiment, the apparatus further comprises a power supply for providing power to components of the device; means for controlling the switching on of different combinations of one or more components of the device; and means for controlling the measurement apparatus to record the electromagnetic radiation emitted by the device when different combinations of the one or more components are switched on. By changing the combination of components that are switched on at any one time, it is possible to analyse the interaction of the electromagnetic radiation between the various components. It is possible for one or more of the components of the device to be switched on and for one or more measurements at different positions of the antenna relative to the device to be taken.

Preferably, the antenna is movable relative to the support to vary the orientation of the antenna relative to a device placed on the support. For example, the antenna may be rotated between 0 and 360°. The feeding spot to the antenna makes a difference to the electromagnetic field generated by the antenna and therefore the signal picked up by the antenna. Varying rotation of the antenna relative to the device enables a series of measurements to be taken at different positions to corroborate initial results.

Preferably, the apparatus further comprises a motor for moving the antenna relative to the support. In a preferred embodiment, the motor is a step motor that enables the antenna to be moved in very small increments both to vary the distance between the antenna and support and to vary the orientation of the antenna relative to the device.

In an embodiment, the motor is arranged to move the antenna relative to the support between a first position and a second position and the measurement apparatus is arranged to record electromagnetic radiation emitted by the device at multiple distances of the antenna relative to the support. Alternatively and/or additionally, the motor is arranged to move the antenna relative to the support between a first orientation and a second orientation and the measurement apparatus is arranged to record electromagnetic radiation emitted by the device at multiple orientations of the antenna relative to the support.

By continuously moving the antenna to different positions relative to the support, it is possible to record a comprehensive set of measurements for comparison. Measurements can be taken at any distances of the antenna from the support and the device. In a preferred embodiment, measurements are taken with a gap of 4mm, 7mm, 12mm and 22mm between the antenna and an upper surface of the device. Likewise, measurements may be taken at different orientations of the antenna relative to the support to verify the results at different distances. For example, in a preferred embodiment, measurements are recorded with an orientation of 0°, 30°, 60°, 90°, 120°, 150° and 180°.

In practice, the device may be placed in any stable position on the support. In a preferred embodiment, the support is arranged to support a device such that the external surface of the device is parallel to the planar antenna.

Two main categories of planar antennae are known and can be used in the present invention, namely magnetic and electric antennae. Electric antennae employ a conductive element, generally a disc of copper or other suitable conductor, as the radiating element. Magnetic antennae use a gap formed in a conductive element (generally referred to as a "slot") as the radiating element. The magnetic and electric type antennae are used to detect differently polarised signals which are emitted by a device. In a preferred embodiment, a magnetic antenna is used because it is smaller whilst being able to maintain a similar return loss performance detecting capability to the electric antenna.

In embodiments of the invention a CPW-Fed circular monopole or other similar antenna may be used. Preferably, an ultrawideband (UWB) elliptical slot antenna is used as the elliptical slot antenna covers a wider band of frequency in the -10dB range. An elliptical slot antenna as described in a paper by Pengcheng Li, Jianxin Liang and Xiaodong Chen in "Study of Printed Elliptical/Circular Slot Antennas for Ultrawideband Applications" has an elliptical slot with a U-shaped tuning stub. Compared with a circular slot antenna whose -10dB impedance bandwidth ranges from 3.75 GHz to 10.3 GHz, the elliptical slot antenna has a wider impedance bandwidth of from 3.1 GHz to 10.6 GHz, whilst also having a more compact size.

The device may be any hand-held electronic device that includes multiple internal components that may emit electromagnetic radiation, for example, a hand-held computer or personal organiser. In a preferred embodiment, the device is a cellular telephone that may include one or more of a camera, radio, MP3 player, etc.

According to a second aspect of the present invention, there is provided a method of detecting electromagnetic radiation emitted by a device at different distances of the device relative to an antenna, the device including multiple components that emit electromagnetic radiation, the method comprising placing the device on a support in a container lined with electromagnetic anechoic absorber; detecting electromagnetic radiation emitted by the device using a planar antenna; taking a first measurement of the detected electromagnetic radiation; moving the antenna relative to the support to vary the distance between the antenna and the device; and taking at least a second measurement of the detected electromagnetic radiation.

Embodiments of the invention will now be described, with reference to the following drawings in which: -
Figure 1 is a schematic view of an example of apparatus according to the present invention for detecting electromagnetic radiation emitted by a device;
Figures 2 and 3 illustrate embodiments of electric and magnetic antennae used in the apparatus together with results showing their measured return loss performances;
Figures 4a and 4b show results using test equipment in accordance with the present invention of the antenna's return loss performance with the device in different positions and at different positions of the antenna relative to the support;
Figures 5 to 10 show results obtained of power level against frequency with the antenna at different distances relative to the support for devices operating at different frequencies;
Figures 11 to 16 show results obtained of power level against frequency with the antenna at different orientations relative to the support for devices operating at different frequencies;
Figures 17 and 18 show graphs of measurements of return loss and system loss respectively against frequency obtained during calibration of the apparatus of the present invention;
Figure 19 shows results obtained from an oscilloscope when obtaining measurements in the time domain using the apparatus of the present invention;
Figure 20 shows the fast fourier transform of the results shown in Figure 19.

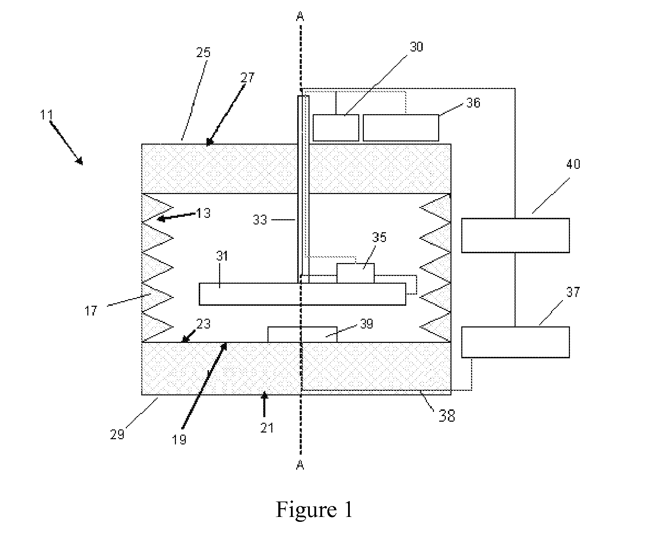

Referring to Figure 1, an example of apparatus for detecting electromagnetic radiation emitted by a device has a sealable container 11. Each interior wall 13 of the container is lined with electromagnetic anechoic absorber material 17. A support 19 is provided inside the container above the layer of anechoic absorber provided at the base 21 of the container 11. In an embodiment, the layer of anechoic absorber provided at the base 21 of the container 11 forms the support 19. The support 19 has a flat upper surface 23 substantially parallel to an external surface 25 of the top 27 and bottom 29 of the container 11.

An antenna 31 is suspended at the end of a controlling rod 33 inside the container 11 above and substantially parallel to the support 19. Using the controlling rod 33 the antenna is movable relative to the support 19. The controlling rod is operable by hand to move the antenna 31. However, in a preferred embodiment, a motor 30 is provided outside the container to move the antenna 31 relative to the support 19. The antenna is moveable along and about an axis A-A of rod 33.

A low noise amplifier (LNA) 35 is located within the container in close proximity to the antenna. A power supply 36 is provided external to the container 11 for powering the motor 30 and the low noise amplifier 35. A signal cable 38 is provided for connecting the device to an external device, for example a computer 37, that can be used to power the device and components of the device and for selectively switching on and off the separate components of the device. In an alternative embodiment, a separate power supply (not shown) is provided for supplying power to the device.

Display means 40, such as an oscilloscope, are provided for displaying and recording the signal detected by the antenna 31.

In use, a device 39, for example a cellular telephone, is placed on the support 19 in the container and the container 11 is sealed. The cellular telephone may be positioned on the support in any direction, for example, with the screen facing down or up. However, in a preferred embodiment, the device is positioned on the support such that an external surface of the device is substantially parallel to the antenna 31.

In addition to standard components required for the device to operate as a phone, the device may also include other components, for example, radio, Bluetooth, MP3 player, camera and the like. The control and power means, namely the signal cable, are used to switch on a combination of one or more of the components of the device while the phone is located in the container. The resulting electromagnetic radiation emitted by the device is detected by the antenna 31. The antenna 31 is moved closer to or further from the device and measurements are taken at various distances of the antenna 31 relative to the support. The orientation of the antenna relative to the device may also be varied and measurements taken at different orientations.

In practice, one or more components of the device are switched on. One, or preferably more, measurements are taken with the antenna in different positions relative to the device 39. For example, measurements may be taken with a gap between the antenna and an upper surface of the device of 4mm, 7mm, 12mm and 22mm. Additionally, measurements may be taken at orientations of the antenna relative to the support of 0°, 30°, 60°, 90°, 120° and 180°.

Once a comprehensive series of measurements have been taken, a different combination of one or more components of the device are switched on and a further series of measurements at different positions of the antenna relative to the support recorded.

The planar antenna 31 used preferably covers the frequency range of 0.8 GHz to 6 GHz and should be small and compact enough to be accommodated in the container 11.

Electric or magnetic antennae may be used in the present invention. Pengcheng Li, Jianxin Liang and Xiadong Chen, in a paper entitled "Study of Printed Elliptical/Circular Slot Antennas for Ultrawideband Applications" discuss various different types of electric and magnetic antennae and describe their respective properties. Any of the described antennae or other known suitable antennae may be used in the present invention. However, in a preferred embodiment, the antenna is one of a CPW-Fed disc monopole antenna with a circular slot or a CPW-Fed elliptical slot antenna.

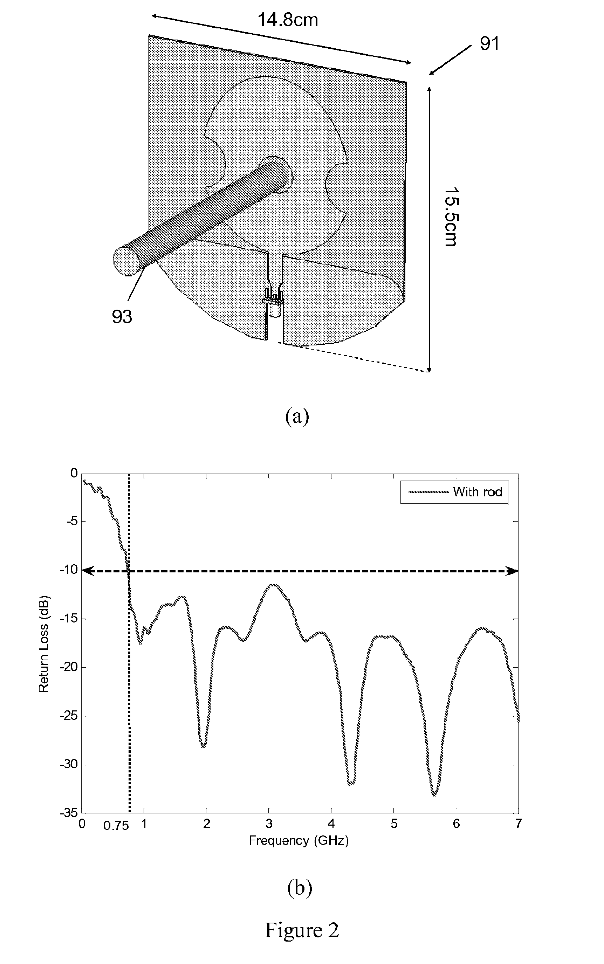

Figure 2a shows a CPW-Fed disc monopole antenna with a circular slot 91 with a controlling rod 93 attached. The return loss versus frequency graph shown in Figure 2b confirms that the measured -10dB impedance bandwidth starts from 0.75 GHz with a rod fixed to the antenna. There is little performance degradation introduced to the antenna when a controlling rod is attached compared with results obtained from similar antennae without a rod attached.

The present inventors have also adapted a CPW-Fed elliptical slot antenna for use in the present invention.

In the study by Li et al. it was found that the slot dimension A and B, feed gap S and slant angle e are the four most critical parameters affecting the performance of a UWB elliptical slot antenna.

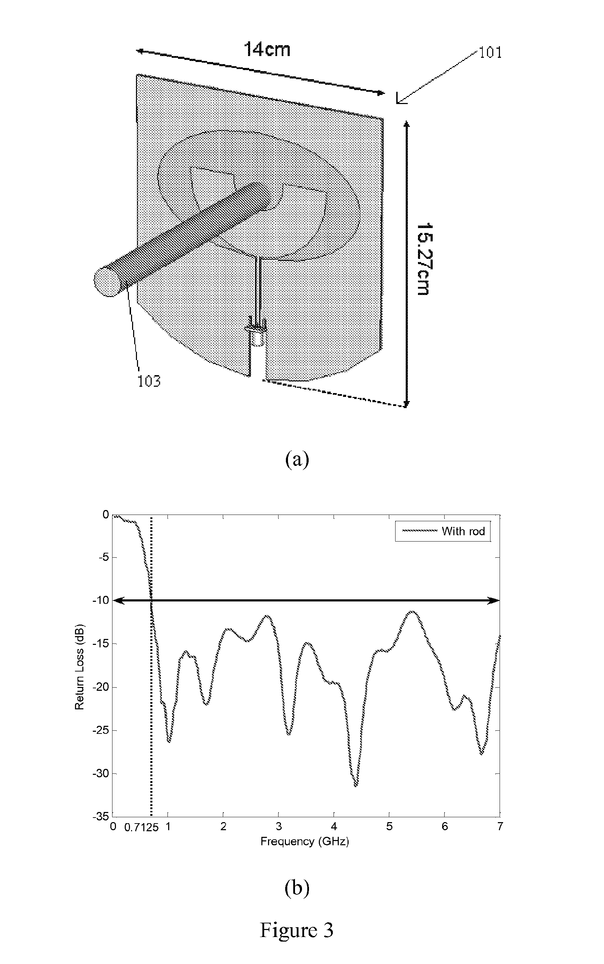

Figure 3(a) shows the CPW-Fed elliptical slot antenna 101 with a controlling rod 103 attached to it. Figure 3(b) shows the return loss performance when the controlling rod 103 is attached and it can be seen that the measured -10dB impedance bandwidth starts from 0.7125 GHz when the controlling rod 103 is attached. Again, there is very little performance degradation with the rod attached compared with previous results obtained without a rod attached.

A low noise amplifier (LNA) is a specific type of electronic amplifier used in communication systems to amplify very weak signals captured by an antenna. If the LNA is located close to the antenna, then losses in the feed line become less visible. The noise of all the respective stages following detection of electromagnetic radiation by an antenna are reduced by the gain of the LNA and the noise of the LNA is injected directly into the received signal. Thus, it is possible for an LNA to boost the desired signal power while adding as little noise and distortion as possible so that retrieval of the signal is possible in the later stages in the system.

In the examples shown above, a wide band LNA is used to amplify the weak interference signals generated by the device's internal components, for example, the camera, display etc. The LNA features a wide operating frequency range from 0.1GHz to 6GHz with a 37dB gain. The maximum gain variation of the LNA is +/- 0.8dB and the maximum noise figure is 1.8dB. The LNA is located directly adjacent the antenna and power is supplied to the LNA through a coaxial cable fed directly into the container from an external power supply 36.

A series of tests in both the frequency domain and the time domain have been carried out by the inventors and the results are presented below. Specifically, the effects of various different devices, detecting antenna orientations and distances relative to the support are considered.

For the frequency domain tests, an elliptical slot antenna is used to conduct the testing while a spectrum analyser is used to obtain the power spectrum. Inside the container, the detecting antenna attached to the controlling tube detects electromagnetic radiation from a device and feeds it to a LNA, which is powered through the coaxial cable. The controlling rod 33 is adjustable to vary the distance between the antenna 31 and the device 39 and to vary the orientation of the antenna 31 relative to the device 39.

### Experiments

In the experiments discussed below, the effects of the gap between the antenna 31 and device 39 are examined. The device, in the experiment a cellular phone handset, is placed in the container 11. The cellular phone handset includes multiple components that emit electromagnetic radiation, including a camera. In a first position the camera is positioned to face the antenna. In a second position the camera faces the support and the base of the container. The camera is switched on during the tests.

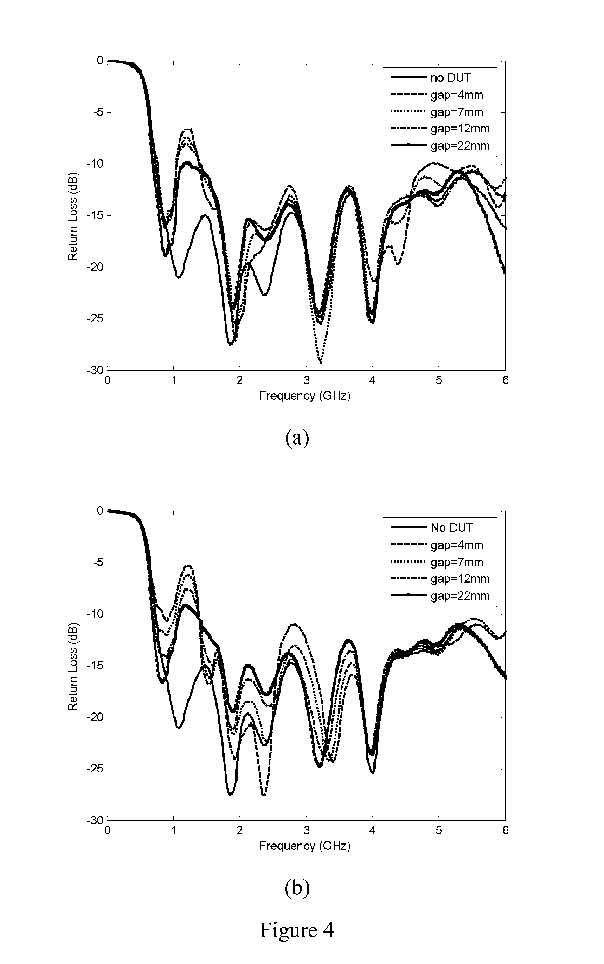

Figure 4 shows the return loss versus frequency at different distances between the detecting antenna and the handset. Figure 4a shows these results when the handset is positioned with its camera facing the antenna and Figure 4b shows these results when the camera is facing away from the antenna. It can be seen from Figures 4a and 4b that the antenna is detuned when positioned too close to the handset. The return loss is at its worst in the frequency range of 1GHz - 1.5GHz. When the gap is bigger than 22mm, the return loss can be retained below -10dB across the entire bandwidth.

Emission tests have been performed in various application bands and the results are given below. In all cases the measurement results have been post-processed by subtracting 37dB which is due to the contribution from the wideband LNA.

### Experiment 1

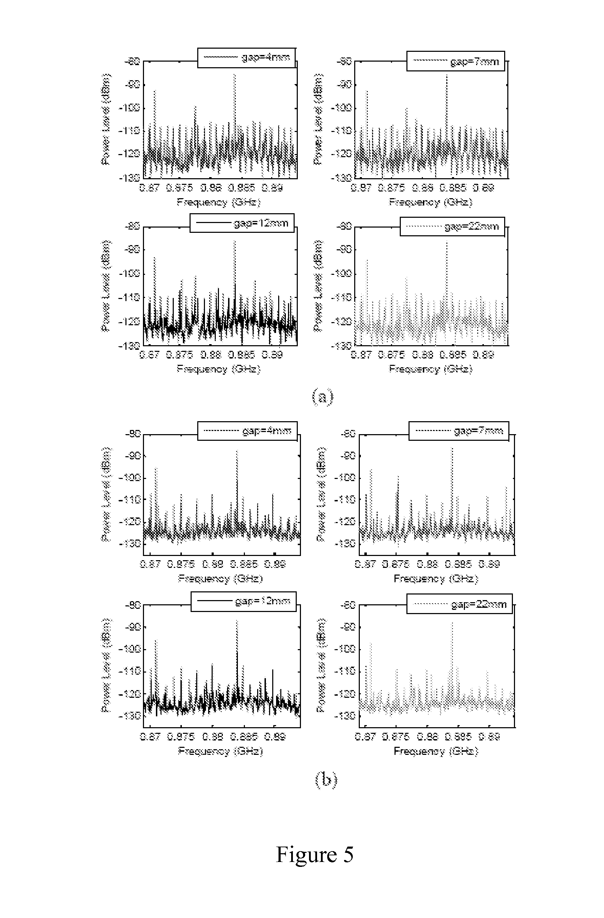

Figures 5a and 5b show the emission from a handset operating under the protocol for Global System for Mobile communications (GSM) in the 850MHz band. It can be seen from the results shown in Figures 5a and 5b that the emission from the handset appears periodical. The results show an improved performance compared with the prior art with noise levels being reduced to about -125dBm. Accordingly, it can be seen that the sensitivity of the testing system has been enhanced.

### Experiment 2

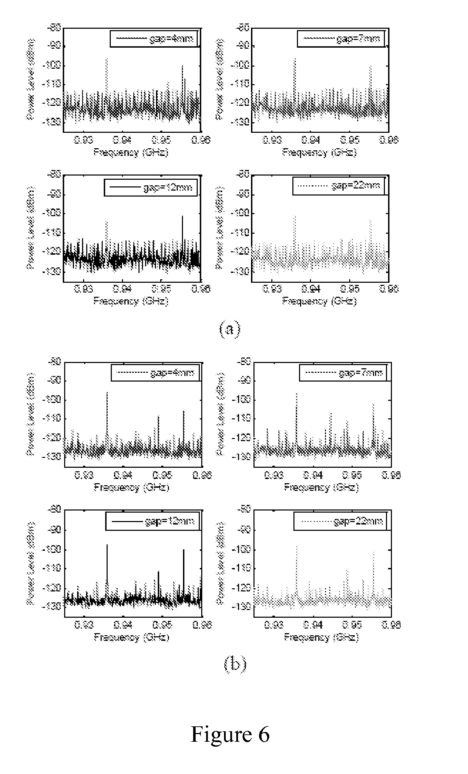

Figures 6a and 6b show the emission from a handset operating under the protocol for Global System for Mobile communications (GSM) in the 900MHz band. The emission also exhibits a periodical appearance. However, the noise level is further diminished to about -128dBm. It can be seen that there is less periodical emission when the camera is positioned to face away from the antenna.

### Experiment 3

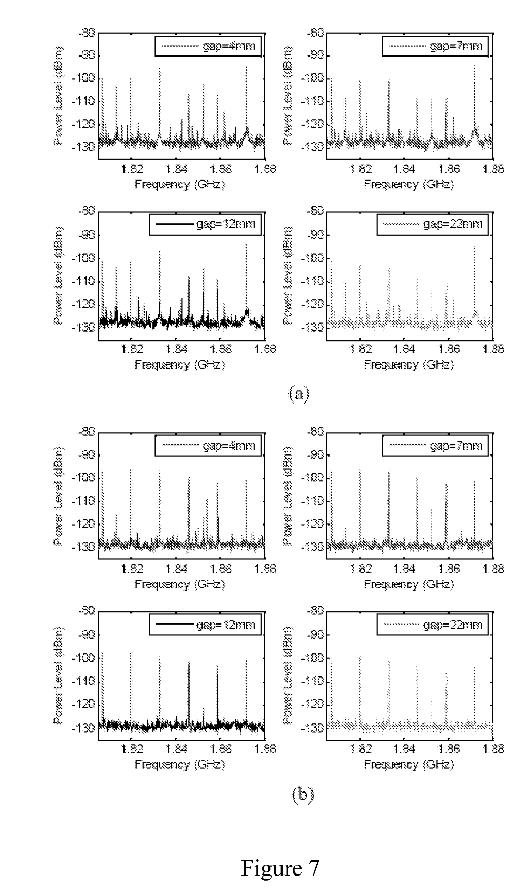

Figures 7a and 7b show the emission from a handset operating under the protocol for a Digital Cellular System (DCS). It can be seen that the noise level continues to reduce by around -130dBm which means there will be an uppermost 35dB margin between the interference signal and the noise level.

### Experiment 4

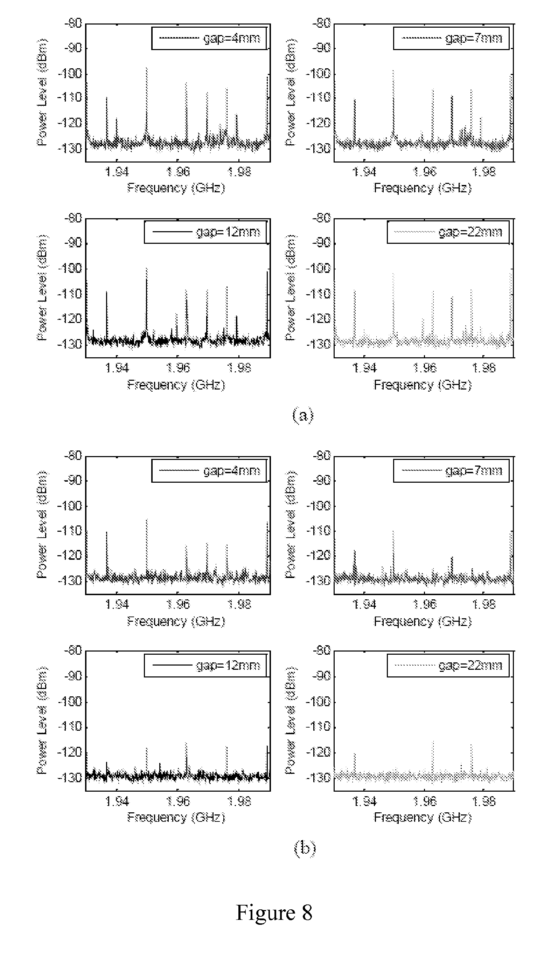

Figures 8a and 8b show the emission from a handset operating under the protocol for a Personal Communications System (PCS) operating in the 1900MHz band. It can be seen that in the PCS frequency band, there is a significant variation in emission between the different positions of the handset. However, the detected noise level is still maintained at around -130dBm.

### Experiment 5

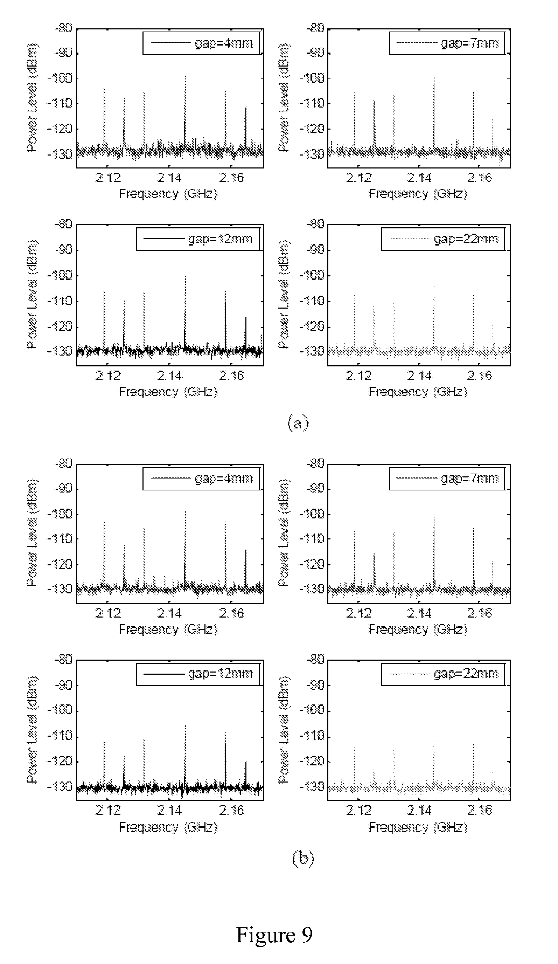

Figures 9a and 9b show the emission from a handset operating under the protocol for a Universal Mobile Telecommunications System (3G). It can be seen that the sensitivity has been significantly improved again. The emission power spectrum in the 3G band does not vary significantly with different positions of the handset.

### Experiment 6

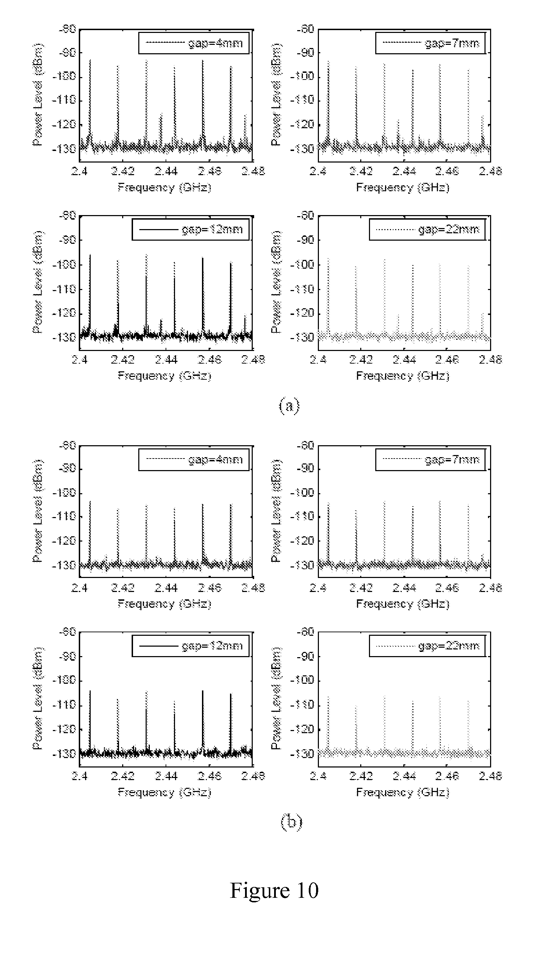

Figures 10a and 10b show the emission from a handset operating under the protocol for Bluetooth. It can be seen from these results that a more pronounced and clear margin between the interference signal and noise level can be achieved.

### Experiments 7 to 12

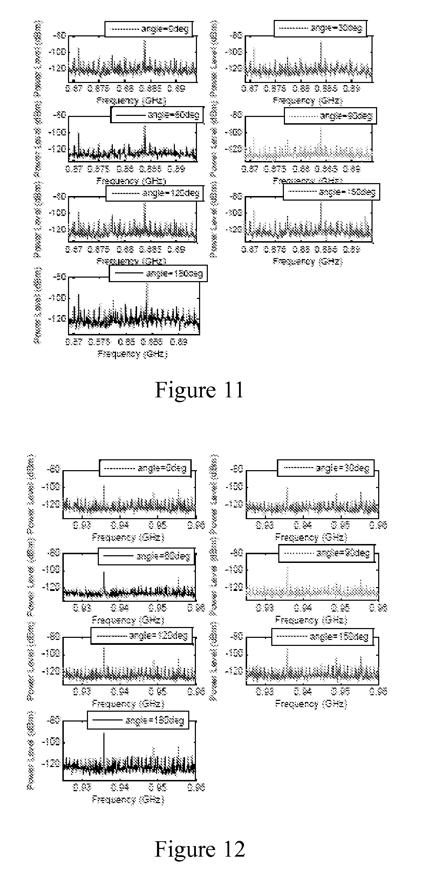

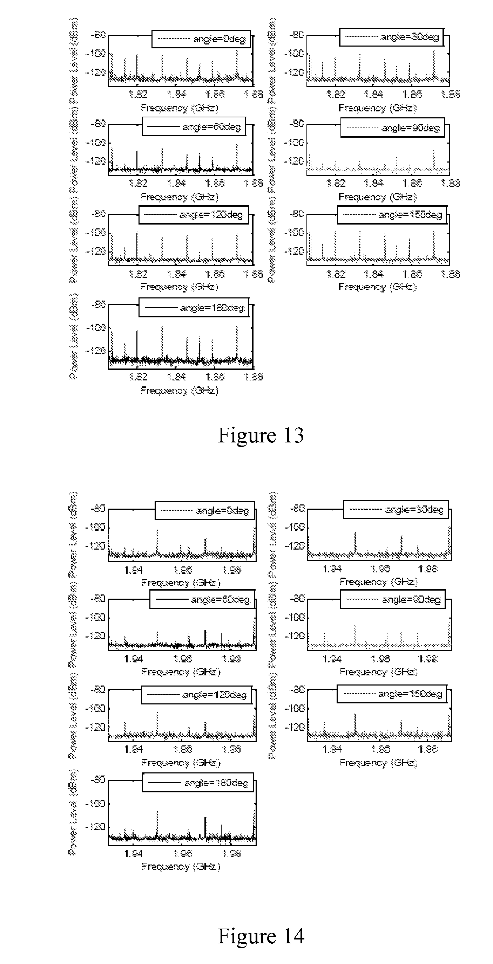

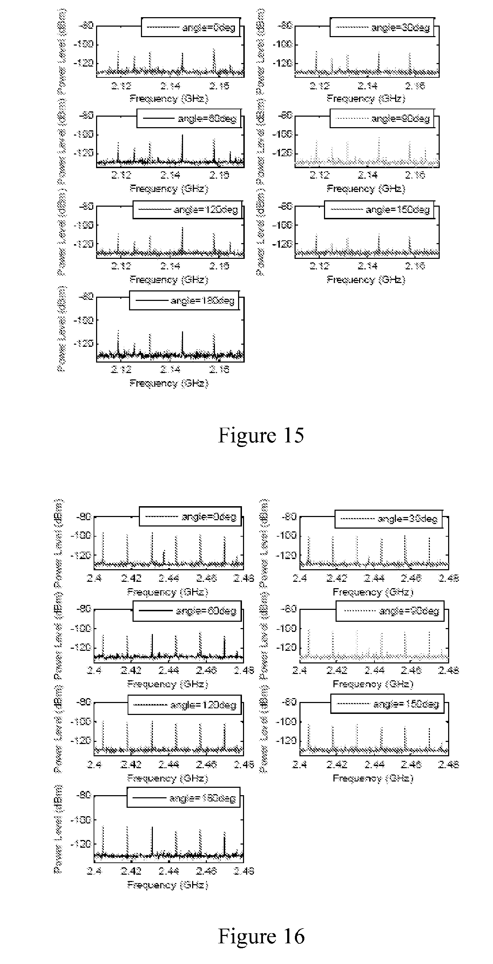

Figures 11 to 16 show results for the different handsets referred to above with different orientations of antenna relative to the device. The handset is placed underneath the slot region of the detecting antenna and the detecting antenna is rotated about the axis A-A of the controlling rod (perpendicular to the surface of the antenna and support) to acquire the emission results. For this experiment, the gap between the antenna and the device was set at 22mm and the handset was positioned with the camera facing the antenna. The camera is switched on during the tests.

It can be seen from the results in Figures 11 to 16 that the performance of the proposed testing box is not sensitive to the orientation of the detecting antenna in all bands although there is degradation at some particular angles, e.g. at 60 degrees.

### Calibration

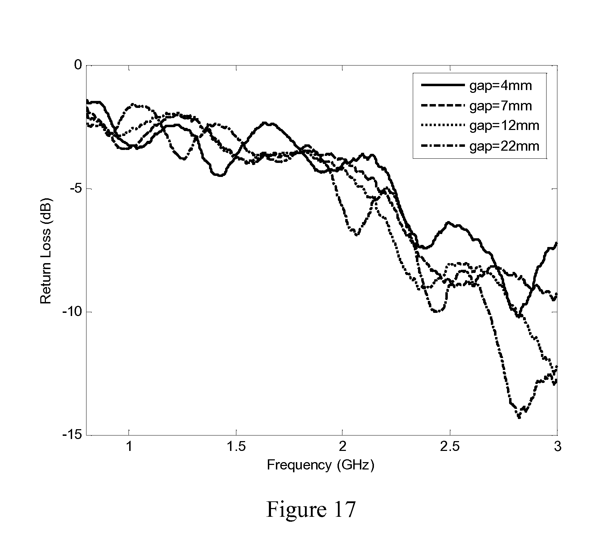

To validate the experimental results shown above, the inventors conducted a calibration for the system. For simplicity, only the central frequency of each application band was chosen to perform the calibration. It can be approximated that the detecting/calibration antenna has the same performance over the relative narrow bandwidth therefore the calibration at the central frequency can approximately represent all other frequencies in each band. A CPW-Fed circular disc monopole antenna is selected as the known antenna as its return loss performance can be obtained by using a HP 8720ES Vector Network Analyser. A HP 8350B Oscillator is employed as the source to provide the power to the known antenna. As the maximum display limit of the spectrum analyzer is +30 dBm and the highest power the oscillator can offer is -2dBm (bearing in mind that there is an additional +37dB LNA gain), a 16dB attenuator is used to ensure the received signal's power will not exceed the upper limit (+30dBm) of the spectrum analyser (-2dBm+37dB-16dB - calibration antenna's loss < +30dBm).
1) The CPW-Fed circular disc monopole antenna is placed underneath the slot region of the detecting antenna and has the same alignment with the detecting antenna. Return loss performances are recorded with various gaps between the detecting antenna and the support, respectively at 4mm, 7mm, 12mm and 22mm as shown in Figure 17.
2) The source is connected with the spectrum analyser through a coaxial cable attached with a -16dB attenuator. The received signal is read and recorded.
3) The coaxial cable is disconnected from the spectrum analyser and connected with the CPW-Fed circular disc monopole antenna. The radiated power from the CPW-Fed circular disc monopole antenna can be approximately obtained (Power from step (2) - Return loss of the CPW-Fed circular disc monopole antenna).
4) the CPW-Fed circular disc monopole antenna is placed underneath the slot region of the detecting antenna with the same alignment again. The received power shown in the spectrum analyser is recorded.
5) The entire testing system can be calculated by Power from step (3) + 37dB - Power from step (4).

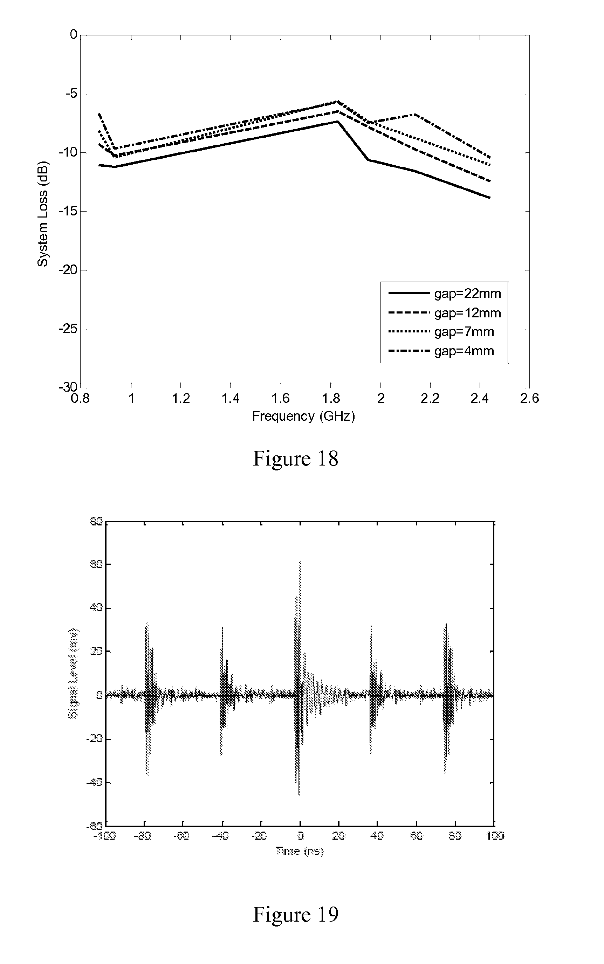

Therefore a system loss curve with various gaps between antenna and support can be generated by applying the above procedure, as shown in Figure 18. It can be seen in Figure 18 that the testing system loss is around 10dB in the entire band.

The measurements provided above have been conducted in the frequency domain. A particular standard will specify the measurement bandwidth and the type of detector to be used. These will determine the permissible sweep rate for the measurement. A major disadvantage of the swept frequency approach is that it possibly can not correctly determine the power spectrum of transient or pulsed emissions that are characteristic of devices that switch heavy loads intermittently when the duration of these emissions is less than the sweep time of the receiver. It is also very time-consuming to perform the swept measurements.

In contrast to the swept frequency approach, the time domain technique uses an ultra fast sampling system to capture a burst of the signal and used fast Fourier transform (FFT) techniques to compute the spectral characteristics from the burst. The upper frequency limit of this approach is set by the Nyquist criterion, which states that the significant advantage of using the time domain approach is that the full spectrum of impulsive emissions can be analysed, provided that the impulse lies wholly within the sampling interval. The measurement time is also reduced massively compared with the frequency domain approach.

The present inventors have carried out a preliminary time domain electromagnetic capability (EMC) measurement. A LeCroy Digital Oscilloscope (SDA 11000) is used to acquire the received pulses. The results obtained by the oscilloscope are shown in Figure 19 and from these it can be seen that the signal level of received pulses is not the real emission level of the handset, it is obtained when the LNA is being switched on. The handset is positioned with the camera facing the antenna for these measurements.

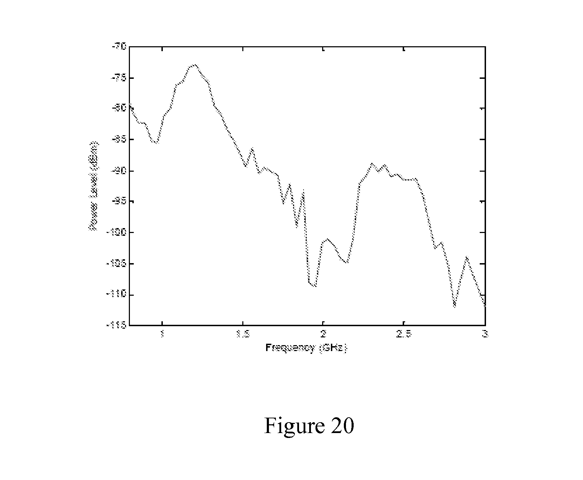

From Figure 19 it can be seen that the emission pulses exhibit a periodical appearance with a repetition period of about 40ns. A FFT of the emission pulses can also be obtained by oscilloscope, as shown in Figure 20. The plot shown in Figure 20 has been post-processed by subtracting the 37dB contributed by the LNA. A straightforward power spectrum comparison was not available between the two oscilloscope readings as the sampling rates for the two pieces of equipment are not identical.

Embodiments of the present invention have been described with particular reference to the examples illustrated. However, it will be appreciated that variations and modifications may be made to the examples described within the scope of the present invention.

## Claims

1. Apparatus for detecting electromagnetic radiation emitted by a device, the device including multiple components that emit electromagnetic radiation, the apparatus comprising:
a container lined with electromagnetic anechoic absorber;
a support located within the container for receiving the device;
a planar antenna located within the container for detecting electromagnetic radiation emitted by the device, the antenna being movable relative to the support to vary the distance between the antenna and the support; and
measurement apparatus for recording the electromagnetic radiation emitted by the device at different positions of the antenna relative to the support.

2. Apparatus as claimed in claim 1, further comprising:
a power supply for providing power to components of the device;
means for controlling the switching on of different combinations of one or more components of the device; and
means for controlling the measurement apparatus to record the electromagnetic radiation emitted by the device when different combinations of the one or more components are switched on.

3. Apparatus as claimed in any preceding claim, the antenna being movable relative to the support to vary the orientation of the antenna relative to a device placed on the support.

4. Apparatus as claimed in any preceding claim, further comprising a motor for moving the antenna relative to the support.

5. Apparatus as claimed in claim 4, wherein the motor is arranged to move the antenna relative to the support between a first position and a second position and the measurement apparatus is arranged to record electromagnetic radiation emitted by the device at multiple distances of the antenna relative to the support.

6. Apparatus as claimed in claim 4 or claim 5, wherein the motor is arranged to move the antenna relative to the support between at least a first orientation and a second orientation and the measurement apparatus is arranged to record electromagnetic radiation emitted by the device at multiple orientations of the antenna relative to the support.

7. Apparatus as claimed in any preceding claim, wherein the support supports a device such that the external surface of the device is parallel to the planar antenna.

8. Apparatus as claimed in any preceding claim, wherein the planar antenna is an electric disc antenna.

9. Apparatus as claimed in any of claims 1 to 7, wherein the planar antenna is a magnetic slot antenna.

10. Apparatus as claimed in claim 9, wherein the magnetic slot antenna has an elliptical slot.

11. Apparatus as claimed in any preceding claim, wherein the device is a hand-held wireless device.

12. Apparatus as claimed in any preceding claim, wherein the device is a cellular telephone.

13. A method of detecting electromagnetic radiation emitted by a device at different distances of the device relative to an antenna, the device including multiple components that emit electromagnetic radiation, the method comprising:
placing the device on a support in a container lined with electromagnetic anechoic absorber;
detecting electromagnetic radiation emitted by the device using a planar antenna;
taking a first measurement of the detected electromagnetic radiation;
moving the antenna relative to the support to vary the distance between the antenna and the device; and
taking a second measurement of the detected electromagnetic radiation.

14. A method as claimed in claim 13, further comprising:
providing power to one or more components of the device;
taking said first and second measurements of electromagnetic radiation emitted by the device; and
switching on a different combination of one or more components in the device and repeating the step of taking first and second measurements of electromagnetic radiation emitted by the device.

15. A method as claimed in claim 14, further comprising:
moving the antenna between a first position and a second position; and
taking a series of measurements of electromagnetic radiation emitted by the device at different distances of the antenna relative to the support.

16. A method as claimed in claim 15, further comprising taking a series of measurements for each different combination of one or more components of the device that are switched on.

17. A method as claimed in claim 13, further comprising:
rotating the antenna about an axis perpendicular to the plane in which the antenna extends to vary the orientation of the antenna relative to a device placed on the support.

18. A method as claimed in claim 17, further comprising:
moving the antenna between a first orientation relative to a device placed on the support and a second orientation relative to a device placed on the support; and
taking a series of measurements of electromagnetic radiation of the device at different orientations of the antenna relative to the support.

19. A method as claimed in claim 18, further comprising taking a series of measurements for each different combination of one or more components of the device that are switched on.
